# EUROPÄISCHE PATENTSCHRIFT

(11) **EP 1 783 245 B1**
(45) Veröffentlichungstag und Bekanntmachung des Hinweises auf die Patenterteilung: **24.01.2018**
(21) Anmeldenummer: 06121043.1
(22) Anmeldetag: 21.09.2006
(51) Int. Cl.: C23C 28/04, C23C 30/00, C23C 14/02, C23C 14/06

(54) **WERKZEUG ODER VERSCHLEISSTEIL SOWIE EIN PVD-BESCHICHTUNGSVERFAHREN ZUM AUFBRINGEN EINER OBERFLÄCHENSCHICHT AUF EINEM WERKZEUG ODER VERSCHLEISSTEIL**
TOOL OR WEAR PART AND PVD COATING METHOD TO DEPOSIT A SURFACE COATING ON A TOOL OR WEAR PART
OUTIL OU PIÈCE D'USURE ET PROCÉDÉDE PVD POUR DÉPOSER UN REVÊTEMENT À LA SURFACE D'UN OUTIL OU D'UN PIÈCE D'USURE

(30) Priorität: 04.11.2005 EP 05405620
(43) Veröffentlichungstag der Anmeldung: 09.05.2007
(60) Teilanmeldung: 10173598.3
(73) Patentinhaber: Oerlikon Surface Solutions AG, Pfäffikon, 8808 Pfäffikon SZ (CH)
(72) Erfinder: Vetter, Jörg, Dr., 51469 Bergisch Gladbach (DE)
(74) Vertreter: Intellectual Property Services GmbH

(56) Entgegenhaltungen:
- EP-A- 0 502 399
- EP-A- 0 534 066
- EP-A- 1 191 582
- EP-A- 1 574 594
- WO-A-2005/078043
- US-A- 5 882 778
- US-A1- 2004 126 237
- HEGEMANN D ET AL: "PACVD-DERIVED THIN FILMS IN THE SYSTEM SI-B-C-N" CHEMICAL VAPOR DEPOSITION, WILEY-VCH VERLAG, WEINHEIM, DE, Bd. 5, Nr. 2, März 1999 (1999-03), Seiten 61-65, XP000833803 ISSN: 0948-1907
- PATENT ABSTRACTS OF JAPAN Bd. 2000, Nr. 13, 5. Februar 2001 (2001-02-05) & JP 2000 297365 A (AGENCY OF IND SCIENCE & TECHNOL; TOHOKU TOKUSHUKO KK), 24. Oktober 2000 (2000-10-24)

## Beschreibung

Die Erfindung betrifft ein mit einer Oberflächenschicht versehenes Werkzeug oder Verschleissteil sowie ein PVD-Beschichtungsverfahren zum Aufbringen einer Oberflächenschicht auf einem Werkzeug oder Verschleissteil gemäss dem Oberbegriff der unabhängigen Ansprüche der jeweiligen Kategorie.

Die Herstellung leistungsfähiger Werkzeuge und Bauteile wird meistens durch eine Beschichtung von deren Oberflächen realisiert. Eine wichtige Klasse solcher beschichteten Werkzeuge sind neben anderen insbesondere zerspanende Werkzeuge in allen möglichen Ausführungsformen. Typische Werkzeugmaterialien, die beschichtet werden, sind unter anderem Werkzeugstähle und Hartmetalle.

Ein bekanntes Problem beim Beschichten dieser Werkstoffe ist dabei, dass beide eine hohe Oxidationsrate an Luft bereits um 500 °C aufweisen und bereits bei relativ niedrigen Temperaturen (ca. HSS 550 °C, Hartmetall 650 °C) erweichen.

Daher kommen insbesondere für die Hartbearbeitung von Stählen bevorzugt auch keramische Schneidkörper, z.B. auf der Basis von kubischem Bornitrid zum Einsatz. So werden zum Beispiel zur Hochgeschwindigkeitsbearbeitung von AI-Legierungen und Grauguß vermehrt verschiedenste SiN-Keramiken eingesetzt. Die Keramiken erweisen sich dabei als wesentlich beständiger gegenüber den metallischen Werkzeugmaterialien. Eine weitere Leistungssteigerung kann durch geeignete Beschichtung der Werkzeuge erreicht werden.

Die aus dem Stand der Technik bekannten Hartstoffschichten basieren dabei häufig auf klassischen Verbindungen wie TiN, TiNC, CrN. Diese bekannten Hartschichten haben in Bezug auf ihren Einsatzbereich aufgrund ihrer speziellen physikalischen Eigenschaften jedoch ihre Grenzen, vor allem bezüglich der Temperaturbelastbarkeit. Einerseits sinkt nämlich die Härte bei erhöhten Temperaturen merklich ab, andererseits setzt bereits bei relativ niedrigen Temperaturen eine Oxidation ein, die zu erhöhtem Schichtverschleiß bei der Einsatztemperatur führen kann.

Um diese Probleme zu umgehen wurden im wesentlichen zwei Schichtklassen entwickelt, die eine Oxidationsbeständigkeit im Bereich bis zu 1000 °C aufweisen und auch bezüglich der Härte verbesserte Eigenschaften haben.

Die eine Schichtklasse betrifft Al-haltige Basisschichten wie AlTiN und AlCrN, wobei, je nach Anforderung zusätzliche Elemente hinzulegiert werden können. Typische Verbindungen aus diesem Bereich sind Verbindungen der Form AlTiXNCO, wobei X z.B. Cr oder ein anderes Metall ist.

Ein anderer im Stand der Technik beschrittener Weg zur Leistungssteigerung beschichteter Werkzeuge besteht in der Kombination von klassischen Hartstoffschichten als Trägerschicht kombiniert mit Finish-Schichten als Funktionsschicht. Insbesondere sind hier als Finish-Schichten die hoch Sihaltigen Schichten (10 at% oder mehr; at% bedeutet dabei im Rahmen dieser Anmeldung "Atomprozent") des Typs MeSiXNCO-Schicht (X weitere Metalle oder B) wie TiSiN zu nennen, die eine deutlich verbesserte Temperaturbelastung ermöglichen. Beispielsweise offenbart die EP-A-1 574 594 der Anmelderin ein Schichtsystem mit einer Al-basierten Hartschicht.

Daneben ist es weiterhin beispielsweise bekannt, oxidische Keramikschichen wie Al₂O₃ mittels CVD-Verfahren auf Wendeschneidplatten abzuscheiden, um den Verschleißprozessen bei erhöhten Kontakttemperaturen, insbesondere beim Drehen begegnen zu können.

Im Stadium der Erforschungen sind darüber hinaus Bor-basierte Schichten, wie zum Beispiel B₄C oder auch kubische BN Schichten. Allerdings hat kubisches BN den entscheidenden Nachteil, dass es äußert kompliziert darstellbar ist. Dies ist vor allem durch Schwierigkeiten beim Schichtwachstum selbst, aber auch durch die hohen Eigenspannungen in den Schichten bedingt.

Im Bereich der Hochtemperaturwerkstoffe wurden in den letzten Jahren Volumenkeramiken auf der Basis von SiCN erzeugt, die sich durch hohe Härten und eine Verbesserung der Oxidationsbeständigkeit gegenüber SiC und Si₃N₄ auszeichnen. Deren besondere Eigenschaften sind durch die komplexen kovalenten chemischen Bindungen und die niedrige Diffusionsrate von Sauerstoff in der amorphen Struktur des SiCN begründet.

Allen bisherigen Bemühungen zum Trotz ist es aber nur teilweise gelungen, Beschichtungen zur Verfügung zu stellen, die den immer höheren Anforderungen an die mechanischen Eigenschaften, wie zum Beispiel Härte und Zähigkeit, tribologische Eigenschaften wie Adhäsionsneigung bei höheren Temperaturen sowie Reibung, die Oxidationsresistenz und anderen charakteristischen Eigenschaften, vor allem auch bei extremen Temperaturen gerecht zu werden.

Ausserdem sind die oben beschriebenen leistungsfähigeren Schichten verfahrenstechnisch sehr schwer herstellbar, so dass die damit beschichteten Werkzeuge sehr teuer sind, so dass sich vom Standpunkt der Wirtschaftlichkeit betrachtet, eine Beschichtung in vielen Fällen nicht lohnt, bzw. solcherart beschichtete Werkzeuge nur einen begrenzten Markt finden.

Die Aufgabe der Erfindung ist es daher, eine verbesserte Beschichtungen für ein Werkzeug oder ein Verschleissteil bereitzustellen, die die aus dem Stand der Technik bekannten Probleme überwindet, und insbesondere ein sich tribologisch positiv auswirkendes Oxidationsverhalten, verbesserte mechanische Eigenschaften, vor allem, aber nicht nur, in Bezug auf die Härte aufweist und auch unter extremen Temperaturbedingungen einsetzbar ist.

Eine weitere Aufgabe der Erfindung ist es, ein PVD-Beschichtungsverfahren anzugeben, mit welchem die erfindungsgemässen Schichten besonders zuverlässig und einfach auf einem Werkzeug oder einem Verschleissteil aufgebracht werden können, wobei möglichst auf aus dem Stand der Technik bereits bekannte Beschichtungsapparaturen zurückgegriffen werden kann, so dass auch der Beschichtungsvorgang selbst besonders wirtschaftlich bewerkstelligt werden kann.

Die diese Aufgaben lösenden Gegenstände der Erfindung sind durch die Merkmale des unabhängigen Anspruchs der jeweiligen Kategorie gekennzeichnet.

Die jeweiligen abhängigen Ansprüche beziehen sich auf besonders vorteilhafte Ausführungsformen der Erfindung.

Die Erfindung betrifft somit ein Werkzeug oder Verschleissteil beschichtet mit einem Schichtsystem mit Schichten in einem weitgehend amorphen Zustand zur Bildung einer Oberflächenschicht auf einer Oberfläche des Substrats, wobei das Schichtsystem mittels PVD hergestellt ist, wobei auf der Oberfläche des Substrats mindestens eine Verbundschicht vorgesehen ist, und weiter mindestens eine erste Hartschicht der Zusammensetzung SiₐB_{b}Me_{c}NᵤCᵥ mit a,b > 0 und 33 at% > c ≥0 und u,v > 0 vorgesehen ist und Me ein Metall ist. Erfindungsgemäss ist auf der ersten Hartschicht eine Sauerstoff-Hartschicht als abschliessende Deckschicht aus SiₐB_{b}CᵥNᵤO_{w}, mit a,b > 0 und u,v, w > 0 vorgesehen.

Die gegenüber dem Stand der Technik erheblich verbesserte Leistungsfähigkeit der Werkzeuge und Bauteile wird somit erfindungsgemäss durch die Verwendung von SiB-Schichten erzielt.

Erfindungsgemäss wird somit vorgeschlagen, den Anteil der metallischen Komponenten der Schichten zu minimieren bzw. ganz zu eliminieren, so dass Si/B dominierende Schichten eingesetzt werden.

Bedingt durch die komplizierte Herstellung von SiBx Keramiken ist darüber relativ wenig bekannt. Es liegen folgende Angaben für SiB₆ Volumenmaterialien vor orthorhombisches Gitter, Härte ca. 2600 , Elastizitätsmodul 290 GPa, Dichte 2,43 g/cm³, thermischer Ausdehnungskoeffizient 4,6 *10⁻⁶/ °C, Wärmeleitfähigkeit 9 W/mK, Schmelzpunkt 1950 °C. Insbesondere ist die hohe Oxidationsbeständigkeit hervorzuheben: stabil in Luft bis 1550 °C.

Diese Stabilität bei hohen Temperaturen wird von den klassischen Schichtsystemen wie AlTiN, AlCrSiN und TiSiN nicht erreicht.

Diese Volumeneigenschaften sind in ähnlicher Form bei Schichten des Typs SiBx hinsichtliche der Härten und der Oxidationseigenschaften zu finden. wobei die Darstellung dieser Schichten mittels der PVD-Beschichtung industrielle Relevanz hat.

Der Mechanismus des Oxidationsschutzes der SiBx-Schichten beruht dabei auf der Ausbildung einer Doppelschicht des Types SiO/BO. Die entstehende äußere Si-reiche Schicht verhindert die Sauerstoffdiffusion in die Schicht.

Dabei hat sich ausserdem überraschend gezeigt, dass eine Beschichtung auf der Basis von SiB-Verbindungen, bzw. von SiBNC in Kombination mit den bekannten klassischen Hartstoffschichten ebenfalls zu den deutlich verbesserten Schichteigenschaften führt.

Je nach Anforderung an die zu beschichtenden Substrate bzw. Werkzeuge kann es im Speziellen besonders vorteilhaft sein, die Schichten mit Sauerstoff zu dotieren, und so zum Beispiel zu SiBNCO-Schichten zu gelangen, die unter anderem durch Voroxidation bzw. durch Verfeinerung der Struktur der Schichten die Diffusion von Sauerstoff reduzieren und die Oxidationsbeständigkeit auch bei hohen Temperaturen massiv erhöhen.

Die Dotierung mit Sauerstoff führt darüber hinaus zu einer Belegung der Korngrenzen mit Sauerstoff, so dass zumindest bei einer partiellen Ausbildung der oben genannten oder anderer Doppelschichtsysteme die Neigung zu Strukturumwandlung in den Schichtsystemen, die oftmals eine mehr oder weniger offene Porosität bzw. Schichtdefekte aufweisen, reduziert wird, da durch die Dotierung mit Sauerstoff eine Voroxidation eingeleitet wird.

Gemäss der vorliegenden Erfindung ist es dabei entscheidend, dass die Schichten mindestens die beiden Elemente Si und B aufweisen, um das erfindungsgemässe Schichtsystem zu bilden, insbesondere um die schützenden Doppelschichten ausbilden zu können. Das heisst, das erfindungsgemässe Schichtsystem umfasst mindestens eine erste Hartschicht der Zusammensetzung SiₐB_{b}Me_{c}NᵤCᵥ mit a,b > 0 und 33at% > c ≥ 0 und u,v>0,wobei Me ein Metall ist, dass im Speziellen z.B. ein für die Targetherstellung zur Abscheidung der erfindungsgemäßen Schicht verwendetes Metall z.B. Al bei SiC, oder aber ein gezielt eingebautes metallisches Element sein kann.

Die Schichten eines erfindungsgemässen Schichtsystems können dabei vorzugsweise auf geeigneten metallischen Zwischenschichten aber auch auf Si, SiC Zwischenschichten sowie direkt auf metallischen oder keramischen Werkzeugmaterialien oder vorzugsweise auf mit Hartstoffschichten beschichteten Werkzeugmaterialien abgeschieden werden.

Bevorzugt, aber nicht notwendig, liegen die Schichten eines erfindungsgemässen Schichtsystems in einem weitgehend amorphen Zustand vor, wobei in einem speziellen Ausführungsbeispiel eine Ausbildung von nanokristallinen Bereichen in den Schichten vorliegt.

Die Schichtdicken liegen dabei im Bereich zwischen ca. 5 nm - 50 000 nm, im Speziellen zwischen 10 nm und 2500 nm, vorzugsweise zwischen (100 - 500) nm und können als Unterschicht z.B. Al-Basishartstoffschichten abgeschieden in gleichen oder in getrennten Anlagen umfassen.

Die metallische Komponente Me des erfindungsgemässen Schichtsystems ist dabei mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm.

Erfindungsgemäss ist auf der Oberfläche des Werkzeugs oder Verschleissteils mindestens eine Verbundschicht, bevorzugt eine Verbundschicht aus MeₓE_{y}N_{z}, mit x,y ≥ 0 und z > 0 vorgesehen, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm und E ein Element aus der Gruppe bestehend aus Si, B, C, O ist.

In einem besonders bevorzugten Ausführungsbeispiel ist eine AlTi-Hartschicht vorgesehen, die zum Beispiel die erste Hartschicht und / oder eine andere Hartschicht sein kann, mit der Zusammensetzung (Al_{1-α-β}Ti_{α}X_{β}) (N_{1-γ}C_{γ}O_{δ}B_{ε}), mit 0.2 < α < 0.6, 0 ≤ β < 0.2 und α+β > 0.01 und 0 ≤ γ < 0.5, 0 ≤ δ < 0.5, 0 ≤ε < 0.5 und γ+δ+ε > 0.01, wobei X ein Element der Gruppe bestehend aus Zr, V, Cr, Nb, Ta; W; Mo; Hf, Mg Si, Y ist.

Die Schichten auf der Basis von SiB werden im Bereich der atomaren Zusammensetzung von Si:B im Bereich von 9 bis 0.1 abgeschieden, wobei die verschiedensten Zusammensetzungen innerhalb einer Gradientenschicht bzw. mehrlagigen Schicht darstellbar sind. Bevorzugt werden Bor-reiche Schichen abgeschieden, d. h: der Si Gehalt ist kleiner als der Borgehalt.

Insbesondere ist die Zusammensetzung mit 6 Boaratomen pro Si-Atom interessant, da sich zumindest lokal die besonders stabile SiB6-Struktur in den Schichten ausbilden kann.

Die Zuführung von N,C;O führt zur Ausbildung verschiedenster Bindungszustände in den Schichten, so treten B-N, B-C, Si-N ,Si-C, Si-O, B-O Bindungen auf, die sich jedoch nur aufwendig quantifizieren lassen. Die kovalenten Bindungsanteile (z.B SiN und BC) bewirken eine hohe Härte. Der strukturelle Mechanismus und der Bindungsmechanismus dieser komplexen Schichten ist beim gegenwärtigen Stand des Wissens nur unzureichend, um Voraussagen über die komplexen Schichteigenschaften zu treffen.

In einer bevorzugten Ausführungsform sollte die atomare Zusammensetzung der Schichtenten im Verhältnis aus ca. gleichen Anteilen von Si und Bor und N bzw. Mischungen aus N,C,O bestehen. Es ist aber auch eine überstöchiometrische Zusammensetzung hinsichtlich des N und C-Gehaltes bezogen auf SiB anstrebenswert, die jedoch herstelltechnisch problematisch ist. Beispielsweise wäre eine solche Schichtzusammensetzung ca. gleiche Anteile von Si, B und C jedoch ca. einen N-Anteil, der das dreifache des Si-Anteiles beträgt entsprechend der Volumenkeramiken sinnvoll.

Bei den oben beschriebenen bevorzugten Zusammensetzungen können zumindest lokal sich hochstabile Verbindungen ausbilden - in Form von Si₃B₃N₇ oder SiBN₃C. Im Gegensatz zu den Keramiken diesen Types handelt es sich naturgemäß bei den PVD-Schichten um Schichten, die PVD spezifische Strukturen wie z.B Wachstumsdefekte, Wachstumsstrukturen sowie Wachstumseigenspannungen aufweisen.

Die Sauerstoffgehalte in den Schichten werden deutlich unter 50 at% vorzugsweise um 10 at% bezogen auf die Gesamtzusammensetzung begrenzt, da der ionische Bindungsanteil, der in der Regel zu sprödem Materialverhalten führt begrenzt werden sollte.

Metallanteile in den Schichten werden sinnvoll ebenfalls mit deutlich unter 50 at% eingestellt, wobei diese meist - außer in den Zwischenschichten - auf maximal 10 At% beschränkt sind. Diese Anteile dienen dabei als Bindungsbrücken zur untereren Hartstoffschicht bzw. entstammen aus den Targetbindemitteln.

Die Härten der Schichten überstreichen dabei den Bereich von ca. 1000 bis 5000 Vickers, bevorzugt zwischen 2000 und 3500 Vickers. Die Auswahl der geeigneten Schicht richtet sich dabei nach den jeweiligen tribologischen Eigenschaften. Beispielsweise ist für verschiedene Mikrowerkzeuge die Reibung aussschlagebend, um Überhitzungen zu vermeiden, so dass reibungsminderene Boroxide wünschenswert sind, wobei schon Schichthärten um 1000 Vickers sinnvoll sein können. Es kommt auf eine tribologische Trennschicht an. In Anwesenheit von Luftfeuchtigkeit wandelt sich das Boroxid zu Borsäure um, wodurch niedrige Reibwerte erreichbar sind.

Bei Kugelfräsern im Kontakt zu Ti-Legierungen sollte hingegen ein hohes Härteniveau eingestellt werden.

Nicht nur, aber auch zur Verbesserung der Hafteigenschaften auf dem Substrat, zum Beispiel auf einem besonders stark beanspruchten Werkzeug, kann zwischen der Verbundschicht und der Hartschicht und / oder zwischen der ersten Hartschicht und der Hartschicht eine Zwischenschicht umfassend die Elemente Si und / oder C vorgesehen sein.

Darüber hinaus kann in einem weiteren Ausführungsbeispiel zwischen der Verbundschicht und der ersten Hartschicht und / oder zwischen der ersten Hartschicht und der Hartschicht eine Gradienten-Mischschicht vorgesehen sein, die die Elemente Si und / oder C der Zwischenschicht und die Zusammensetzung SiₐB_{b}Me_{c}NᵤCᵥO_{w}, insbesondere SiₐB_{b}Me_{c}CᵥNᵤ, im speziellen SiₐB_{b}CᵥNᵤ der ersten Hartschicht umfasst. Die Zusammensetzung der Gradienten-Mischschicht ändert sich dabei mehr oder weniger kontinuierlich von der Zusammensetzung einer ersten Schicht, mit der die Gradienten-Mischschicht in Kontakt ist, zu der Zusammensetzung einer zweiten Schicht, mit der die Gradienten-Mischschicht ebenfalls in Kontakt ist, so dass die erste und die zweite Schicht, die zum Beispiel verschiedene chemische und / oder physikalische Eigenschaften, wie Gitterstruktur, Kristallinität, thermische Ausdehnung usw. haben können, optimal aufeinder anpassbar.

Erfindungsgemäss ist eine Sauerstoff-Hartschicht aus SiₐB_{b}NᵤCᵥO_{w} vorgesehen, die als Deckschicht vorgesehen ist. Diese Deckschicht kann zum Beispiel, aber nicht nur die Diffusion von Sauerstoff in die Schicht unterbinden oder minimieren, dadurch unter anderem die Oxidationsfestigkeit erhöhen. Ausserdem kann die Deckschicht dem Schichtsystem gegen Angriffe von aussen, besondere chemische, thermische und mechanische Eigenschaften verleihen, so dass das Schichtsystem durch die Deckschicht zum Beispiel besonders gut gegen die hohe Temperatur geschützt ist und / oder besonders vorteilhafte mechanische Eigenschaften, oder besonders gute tribologische Eigenschaften aufweisen.

Die Schichtdicke der Verbundschicht und / oder der Zwischenschicht und/ oder der Hartschicht und / oder der ersten Hartschicht und / oder der Gradienten-Mischschicht und / oder der Sauerstoff-Hartstoffschicht und / oder der Deckschicht liegen dabei bevorzugt zwischen 5 nm und 50000 nm, vor allem zwischen 10 nm und 5000 nm, im besonderen zwischen ca. 50 nm - 5 000 nm, vorzugsweise zwischen 100 nm- 500nm, Speziellen zwischen 80 nm und 600 nm.

Die Schichtdicke der Verbundschicht liegt bevorzugt zwischen 100 nm und 50 000 nm, im besonderen zwischen 100 nm und 3000 nm, die Schichtdicke der ersten Hartschicht zwischen 100 nm und 3000 nm, bevorzugt zwischen 400 nm und 600 nm, die Schichtdicke der Zwischenschicht und / oder der Gradienten-Mischschicht zwischen 20 nm und 500 nm, bevorzugt zwischen 50 nm und 120 nm und eine Schichtdicke der Sauerstoff- Hartschicht zwischen 10 nm und 100 nm, bevorzugt zwischen 40 nm und 60 nm.

Es versteht sich, dass die zuvor beschriebenen Ausführungsbeispiele der Erfindung, je nach Anwendung, auch in jeder geeigneten Weise kombinierbar sind und insbesondere die exemplarisch dargestellten Schichtabfolgen auch in anderer Weise realisiert sein können und eine oder mehrere der Schichten in einem speziellen Ausführungsbeispiel eines erfindungsgemässen Schichtsystems ganz fehlen können oder in einem anderen Ausführungsbeispiel in ein und demselben Schichtsystem auch mehrfach vorkommen können.

Die Erfindung betrifft weiter ein PVD-Beschichtungsverfahren zum Aufbringen eines erfindungsgemässen Schichtsystems auf eine Oberfläche eines Werkzeugs oder eines Verschleissteils, in einer Prozesskammer einer Beschichtungsvorrichtung mit einer RF-Beschichtungsquelle mit einem RF-Magnetron und / oder einer DC-Beschichtungsquelle, insbesondere mit einem DC-Magnetron, wobei die RF-Beschichtungsquelle und / oder die DC-Beschichtungsquelle durch eine Blende verschlossen werden kann, und Mittel vorgesehen sind, so dass der Prozesskammer ein Prozessgas zuführbar ist, und das Verfahren die folgenden Verfahrensschritte umfasst:
a.) Einbringen des Substrats in die Prozesskammer;
b.) Erhitzen des Substrats auf die lonenreinigungstemperatur;
c.) lonenereinigung des Substrats bei der lonenreinigungstemperatur;
d.) Abscheiden einer Verbundschicht auf der Oberfläche des Werkzeugs oder Verschleissteils,
e.) Abscheidung einer ersten Hartschicht der Zusammensetzung SiₐB_{b}Me_{c}NᵤCᵥ mit a,b > 0 und 33 at% > c ≥0 und u,v > 0, wobei Me ein Metall ist, unter Verwendung der RF-Beschichtungsquelle und / oder der DC-Beschichtungsquelle
f.) Zugabe eines Reaktivgases, insbesondere Sauerstoff, Stickstoff oder ein Kohlenstoff enthaltendes Gas, in die Prozesskammer und Bildung einer Sauerstoff-Hartschicht als abschliessende Deckschicht aus SiₐB_{b}CᵥNᵤO_{w} mit a,b > 0 und u,v, w > 0.

Speziell kann dabei gelten a+b+c = 100%, was einerseits bedeuten kann, dass eine Schicht eines erfindungsgemässen Schichtsystems z.B. nur Si, B und eine Metall enthält.

In einem anderen Beispiel kann die Aussage a+b+c = 100% aber auch bedeuten, dass eine Zählweise für den Anteil der in der Verbindung SiₐB_{b}Me_{c}NᵤCᵥO_{w} enthaltenen Elemente gewählt ist, die die beiden Elementgruppen (SiₐB_{b}Me_{c}) und (NᵤCᵥO_{w}) getrennt in der Weise zählt, dass die beiden Summen (a+b+c) und (u+v+w) jeweils getrennt 100% ergeben, wobei, wie erwähnt, die Elemente N und / oder C und / oder O auch ganz fehlen können. Ein Beispiel für die zuvor eingeführte Zählweise zur Angabe einer Zusammensetzung wäre etwa Si_{0.3}B_{0.6}Cr_{0.1}N_{0.2} C_{0.5}O_{0.3}. Das heisst, die Angabe der Zusammensetzung erfolgt derart, dass Si, B und Me (hier Cr) zusammen 100% ergeben und die zweite Element-Gruppe N, C und O sich ebenfalls zu 100% addieren.

In einem für die Praxis besonders wichtigen Ausführungsbeispiel umfasst das PVD-Beschichtungsverfahren die folgenden Verfahrensschritte: Einbringen des Werkzeugs oder Verschleissteils in die Prozesskammer; Erhitzen des Werkzeugs oder Verschleissteils auf eine lonenreinigungstemperatur; lonenereinigung des Werkzeugs oder Verschleissteils bei der lonenreinigungstemperatur und Anlegen einer Bias Gleichspannung und / oder einer RF-Spannung an das Substrat zur lonenreinigung; Öffnen der Blende der DC-Beschichtungsquelle und / oder der Blende einer ersten RF-Beschichtungsquelle; Abscheiden einer Verbundschicht auf der Oberfläche des Werkzeugs oder Verschleissteils, insbesondere einer Verbundschicht aus MeₓE_{y}N_{z}, mit x,y ≥ 0 und z > 0, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist, und E ein Element aus der Gruppe Si, B, C, O ist; Deaktivieren der DC-Beschichtungsquelle und / oder der ersten RF-Beschichtungsquelle, Öffnen einer Blende einer zweiten RF-Beschichtungsquelle und in Betriebnahme der zweiten RF-Beschichtungsquelle; Abscheiden einer Zwischenschicht umfassend die Elemente Si und / oder C mittels der zweiten RF-Beschichtungsquelle; Öffnen einer Blende einer dritten RF-Beschichtungsquelle, in Betriebnahme der dritten RF-Beschichtungsquelle und im Parallebetrieb mit der zweiten RF-Beschichtungsquelle Abscheidung von SiₐB_{b}Me_{c}NᵤCᵥO_{w}, insbesondere von SiₐB_{b}Me_{c}CᵥNᵤ, im speziellen von SiₐB_{b}CᵥNᵤ der ersten Hartschicht mittels der zweiten RF-Beschichtungsquelle zur Bildung einer Gradienten-Mischschicht; Deaktivieren der zweiten RF-Beschichtungsquelle und Abscheiden einer ersten Hartschicht aus SiₐB_{b}Me_{c}NᵤCᵥO_{w}, insbesondere SiₐB_{b}Me_{c}CᵥNᵤ, im speziellen SiₐB_{b}CᵥNᵤ beim Weiterbetrieb der dritten RF-Beschichtungsquelle bis zu einer vorgegebenen Beschichtungsdicke der ersten Hartschicht; Zugabe eines Reaktivgases, insbesondere Sauerstoff, Stickstoff oder ein Kohlenstoff enthaltendes Gas, in die Prozesskammer und Bildung einer Sauerstoff-Hartschicht mit der Zusammensetzung SiₐB_{b}Me_{c}NᵤCᵥO_{w}.

In einem besonders bevorzugten Ausführungsbeispiel ist die DC-Beschichtungsquelle und / oder die RF-Beschichtungsquelle eine Sputterquelle und / oder eine Lichtbogen-Verdampfungsquelle ist.

Der Beschichtungsvorgang selbst kann gemäss einem erfindungsgemässen Verfahren mittels eines PVD-Verfahrens, bevorzugt mittels RF-Sputtern und / oder DC-Sputtern und / oder mittels eines CVD-Verfahrens, bevorzugt mittels PE-CVD und oder Laser-CVD, und / oder mittels Laserablation und /oder mittels einem Lichtbogenverdampfungsverfahren, insbesondere mittels einem kathodischen und / oder anodischen Lichbogenverdampfungsverfahren durchgeführt werden.

Bevorzugt, aber nicht notwendig, wird dabei diejenige Schicht des Schichtsystems, die unmittelbar auf der Oberfläche des Substrats, zum Beispiel unmittelbar auf der Oberfläche eines Werkzeugs abgeschieden wird, mittels eines Lichbogen-Verdampfungsverfahrens, z.B. durch anodische und / oder kathodische Lichtbogenverdampfung aufgebracht.

In einem speziellen Ausführungsbeispiel eines erfindungsgemässen Beschichtungsverfahrens wird nach der lonenreinigung des Substrats und vor der Abscheidung der Hartschicht, eine Verbundschicht, insbesondere eine Verbundschicht aus AlₓCr_{y}N_{z}, mit x,y,z ≥ 0, auf der Oberfläche des Substrats, und zwar bevorzugt mit der DC-Beschichtungsquelle abgeschieden.

In einem anderen Ausführungsbeispiel wird zwischen der Verbundschicht und der ersten Hartschicht, eine Zwischenschicht umfassend die Elemente Si und / oder C abgeschieden.

In einem weiteren Ausführungsbeispiel wird zwischen der Verbundschicht und der ersten Hartschicht eine Gradienten-Mischschicht abgeschieden wird, die die Elemente Si und C der Zwischenschicht und die Zusammensetzung SiₐB_{b}MeCᵥNᵤ, insbesondere SiₐB_{b}CᵥNᵤ der ersten Hartschicht umfasst.

Dabei kann in einem anderen für die Praxis besonders wichtigen Ausführungsbeispiel eines erfindungsgemässen Verfahrens auf die Verbundschicht und / oder auf die erste Hartschicht und / oder auf die Zwischenschicht und / oder auf eine Sauerstoff-Hartschicht, eine Sauerstoff-Hartschicht aus SiₐB_{b}MeNᵤCᵥO_{w}, im Speziellen eine Sauerstoff-Hartschicht aus SiₐB_{b}NᵤCᵥO_{w} als Deckschicht auf dem Substrat abgeschieden werden.

In einem ganz speziellen Ausführungsbeispiel kann zwischen zwei Schichten des Schichtsystems, also zum Beispiel zwischen der Verbundschicht und der Zwischenschicht und / oder zwischen der Zwischenschicht und der Hartschicht und / oder zwischen der Hartschicht und der Deckschicht und / oder zwischen zwei andren Schichten eines erfindungsgemässen Schichtsystems eine metallische Zwischenschicht, z.B. eine Chrom, Aluminium oder eine andere metallische Zwischenschicht als Bindeschicht zur besseren Verbindung zweier Schichten vorgesehen sein, wobei eine solche metallische Zwischenschicht unter anderem auch dazu beitragen kann, Eigenspannungen in bzw. zwischen zwei aufeinander folgenden Schichten abzubauen.

Die lonenreinigungstemperatur bei einem erfindungsgemässen Verfahren liegt dabei bevorzugt zwischen 100°C und 1000°C, im Speziellen zwischen 250°C und 800°C liegt und die lonenreiningung wird vorzugsweise, aber nicht notwendig, mit gepulster Vorspannung des Substrats durchgeführt. Ebenso kann während der Bildung der Zwischenschicht und / oder der Gradienten-Mischschicht an das Substrat eine elektrische RF-Spannung angelegt werden.

Es versteht sich, dass die zuvor diskutierten Ausführungsvarianten von erfindungsgemässen Verfahren lediglich exemplarisch zu verstehen sind, und insbesondere im speziellen Fall die vorgestellten Verfahren auch in jeder geeigneten Weise kombiniert werden können.

Die Erfindung betrifft weiterhin ein Werkzeug oder Verschleissteil, mit einem erfindungsgemässen Schichtsystem und / oder das mit einem erfindungsgemässen Verfahren aufgebracht wurde.

Das Werkzeug kann dabei unter anderem ein spannendes Werkzeug, insbesondere ein Bohrer, ein Fräser, eine Wendeschneidplatte für einen Dreh- oder Fräsprozess, ein Hobelwerkzeug, ein Umformwerkzeug oder ein Mikrowerkzeug, insbesondere ein Mikrobohrer, eine Mikrowendeschneidplatte, ein Mikrofräser oder ein anderes Werkzeug oder ein anderes Mikrowerkzeug oder ein Kunststoffwerkzeug sein.

Dabei kann die erfindungsgemässe Schicht auch besonders vorteilhaft auf ein Verschleissteil für eine Luft- oder Land gestützte Turbine, einen Motor, im Speziellen für einen Verbrennungsmotor, im speziellen auf eine Dichtung, ein Zahnrad, einen Kolben oder auf ein anderes Verschleissteil als Beschichtung aufgebracht werden.

Im folgenden wird die Erfindung an Hand der schematischen Zeichnung näher erläutert. Es zeigen:
- Fig. 1: ein erfindungsgemässes Schichtsystem;
- Fig. 2: eine Beschichtungsvorrichtung zur Durchführung des erfindungsgemässen Verfahrens.

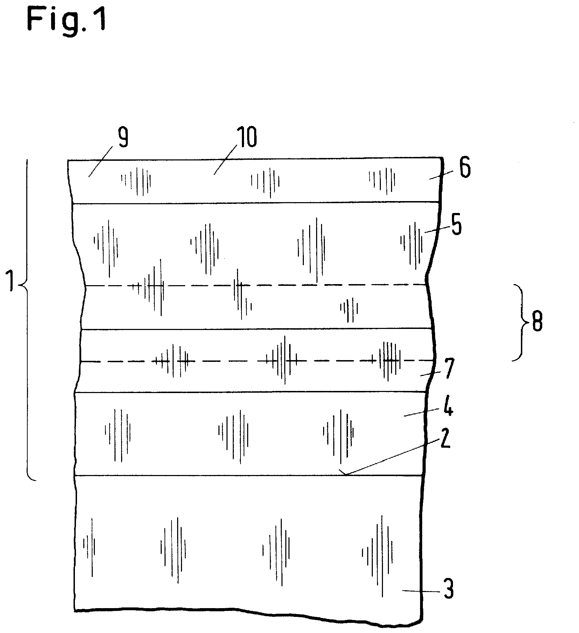

In Fig. 1 ist schematisch ein erfindungsgemäßes Schichtsystem dargestellt, das im folgenden gesamthaft mit dem Bezugszeichen 1 bezeichnet wird.

Auf dem Werkzeug oder Verschleissteil 3, das zum Beispiel ein zerspanendes Werkzeug 3 sein kann, ist eine Verbundschicht 4 aufgebracht. Im vorliegenden Ausführungsbeispiel ist die Verbundschicht 4 eine Verbundschicht 4 aus MeₓE_{y}N_{z}, mit x,y ≥ 0 und z > 0, wobei Me mindestens ein Metall aus der Gruppe Al, Cr, Mo, W, Sc, Y, La, Ti, Zr, Hf, V, Nb, Ta, Mn, Tc, Re, Fe, Co Ni, Li, Ce ist und E ein Element aus der Gruppe Si, B, C, O ist. Speziell ist die Verbundschicht 4 eine AlCrN-Schicht und hat eine Dicke von ca. 2500 nm.

Auf die Verbundschicht 4 ist eine SiC Zwischenschicht 7 aufgebracht, die zum Beispiel eine Dicke von ca. 100 nm hat, und auf die Zwischenschicht 7 folgt dabei eine erste Hartschicht 5, die im vorliegenden Beispiel eine Dicke von ungefähr 500 nm aufweist. Die erste Hartschicht 5 ist eine SiₐB_{b}Me_{c}NᵤCᵥO_{w} Hartschicht 5, insbesondere eine erste Hartschicht 5 aus SiₐB_{b}Me_{c}CᵥNᵤ, im speziellen eine Hartschicht 5 aus SiₐB_{b}CᵥNᵤ, mit a,b > 0 und 33 at% > c ≥0 und u,v,w ≥ 0, und wobei Me ein Metall ist. Bei dem in Fig. 1 dargestellten speziellen Fall ist die erste Hartschicht 5 beispielsweise eine SiBCN Hartschicht 5.

In einem speziellen Beispiel eines Schichtsystems gemäss Fig. 1 kann die Verbundschicht eine Dicke von 20nm - 50000nm, die Zwischenschicht eine Dicke von 10nm - 1000nm, die Hartschicht eine Dicke von 100nm - 5000nm und die Deckschicht eine Dicke zwischen 5nm und 500nm aufweisen.

Bevorzugt hat dabei die Verbundschicht eine Dicke von 100nm - 2500nm, die Zwischenschicht eine Dicke von 20nm - 500nm, die Hartschicht eine Dicke von 100nm - 2500nm und die Deckschicht eine Dicke zwischen 10nm und 50nm.

Der Übergang zwischen der SiC Zwischenschicht 7 und der ersten Hartschicht 5 erfolgt über eine Gradienten-Mischschicht 8. Die Gradienten-Mischschicht 8 umfasst die Elemente Si und / oder C der Zwischenschicht 7 und die Zusammensetzung SiₐB_{b}Me_{c}NᵤCᵥO_{w}, insbesondere SiₐB_{b}Me_{c}CᵥNᵤ, im speziellen SiₐB_{b}CᵥNᵤ der ersten Hartschicht 5, so dass ein mehr oder weniger kontinuierlicher Übergang von der Zusammensetzung der Zwischenschicht 7 zur ersten Hartschicht 5, um umgekehrt, gewährleistet ist.

Als abschliessende Deckschicht 10 ist eine Sauerstoff-Hartschicht 9 aus SiₐB_{b}NᵤCᵥO_{w} vorgesehen, die das Schichtsystem 1 zur äusseren Umgebung abschliesst.

Dabei kann in einem speziellen Ausführungsbeispiel die Deckschicht 10 auch als Hartschicht 6 ausgebildet sein.

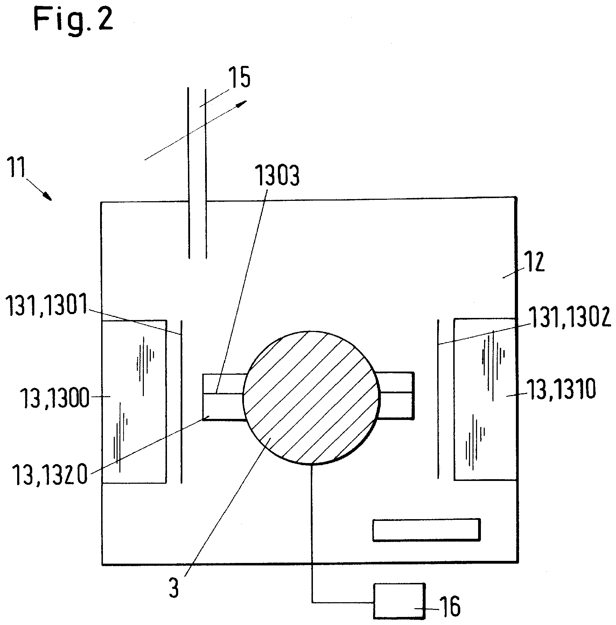

In Fig.2 ist schematisch der Aufbau einer Beschichtungsvorrichtung 11 dargestellt, die sich besonders vorteilhaft zur Durchführung des erfindungsgemässen Beschichtungsverfahrens eignet. Die an sich bekannte Beschichtungsvorrichtung 11 umfasst die Prozesskammer 12, in welcher Prozesskammer 12 bei der in Fig. 2 dargestellten speziellen Beschichtungsvorrichtung 11 drei verschiedene Beschichtungsquellen vorgesehen sind, nämlich die beiden RF-Beschichtungsquellen 1300 und 1310, die jeweils an einer darstellunggemäss rechten und linken Prozesskammerwand vorgesehen sind, und die DC-Beschichtungsquelle 13, 1320, die einer Rückwand der Prozesskammer 12 angeordnet ist. Alle Beschichtungsquellen 1300, 1310, 1320 besitzen jeweils eine Blende 131, mit der jede der Beschichtungsquellen 1300, 1310, 1320 separat und unabhängig voneinander abschirmbar sind, so dass dadurch z.B. die entsprechende Beschichtungsquelle für den Beschichtungsvorgang deaktiviert werden kann, ohne dass die Bechichtungsquelle als solches abgeschaltet werden muss.

Zum Einbringen eines Prozessgases, z.B das Sputtergas Argon oder die Reaktivgase, N₂; O₂,C₂H₂ oder auch anderer Gas in die Prozesskammer 12 sind Mittel 15 vorgesehen, die im vorliegenden Fall eine absperrbare Zuleitung 15 ist. Das zu beschichtende Substrat 3 ist in der Prozesskammer auf einem nicht dargestellten Halter angeordnet und zum Anlegen einer Bias-Gleichspannung 16 oder einer RF-Spannung 16 mit einem Spannungsgeber verbunden.

Um die Funktionsweise der Beschichtungsvorrichtung 11 während der Durchführung eines erfindungsgemässen PVD-Beschichtungsverfahrens zu erläutern, wird im folgenden exemplarisch ein Beschichtungsprozess zur Beschichtung eines Werkzeugs 3 oder Verschleissteils 3 beschrieben, der für die Praxis von besonderer Bedeutung ist.

Nach dem das Werkzeug 3 oder Verschleissteil 3 in die Prozesskammer eingebracht worden ist, wird zunächst eine Erwärmung des Werkzeugs 3 oder Verschleissteils 3 bei geschlossenen Blenden 131, die häufig auch als Shutter 131 bezeichnet werden, bevorzugt bei 250 - 800 °C durchgeführt. Dann erfolgt eine lonenreinigung mit gepulster Vorspannung 16 (AAFP asymmetric alternating field pulsing) des Werkzeugs 3. Im nachfolgendem ersten Beschichtungsprozeß wird die Blende 131 der DC-Beschichtungsquelle 13, 1320 geöffnet und z.B. eine AlCrN-Verbundschicht 4 abgeschieden. Das Aufbringen der Verbundschicht 4 kann durch DC-Sputtern oder aber auch DC-Arc-Verdampfung erfolgen. Während der Abscheidung wird an das Werkstück 3 eine Bias-Spannung 16, bevorzugt eine negative Bias-Vorspannung 16 von ca. 10 - 400 V angelegt, es kann aber auch eine gepulste Vorspannung mit wechselnder Polarität (AAFP) eingesetzt werden. Die Frequenzen sind dann zum Beispiel im Bereich von 0,1 bis 300 kHz zu wählen, die positive Vorspannung liegt insbesondere im Bereich von 3 bis 100 V. Die Puls/Pausenverhältnisse können im Bereich von 0,1 bis 0,95 liegen.

Während des Abscheidens der Verbundschicht wird bereits das erste RF-Magnetron 1310 bei geschlossenem Shutter 131 aktiviert.

Anschließend wird der Sutter 131 geöffnet und je nach gewünschter Zwischenschicht ein Parallelbetrieb des DC-Magnetrons 13, 1320 und des RF-Magnetrons 1310 vorgenommen. Zur Einstellung eines Gradienten kann die Entladungsleistung der Magnetrons in geeigneter Weise verändert werden.

Dann wird die Blende 1303 der DC-Beschichtungsquelle 1320 geschlossen und die DC-Beschichtungsquelle für den Beschichtungsvorgang deaktiviert.

Vorzugsweise wird nun bereits an das Substrat 3 eine RF-Spannung angelegt.

Die RF-Beschichtungsquelle 1310 dient zur Abscheidung einer SiCx Zwischenschicht 7. Sie ist mit einem Si-Target oder SiC-Target bestückt.

Während des Abscheidens der Zwischenschicht wird bereits das zweite RF-Magnetron 1300 bei geschlossenem Shutter 131 aktiviert.

Nach dem Erreichen der Zielschichtdicke wird in einem weiteren Schritt nun die Blende 131 der RF-Beschichtungsquelle 1300 geöffnet.

Je nach gewünschter Zwischenschicht in Form einer Gradientenschicht wird ein Parallelbetrieb des ersten RF-Magnetrons 1310 und des RF-Magnetrons 1300 vorgenommen. Zur Einstellung des Gradienten kann die Entladungsleistung der Magnetrons in geeigneter Weise verändert werden.

Dann wird die Blende 131 des RF-Magnetrons 1310 geschlossen und für den Beschichtungsvorgang deaktiviert.

Die RF-Beschichtungsquelle 1300 dient der Abscheidung z.B. einer SiBNC-Schicht als erste Hartschicht 5. Die RF-Beschichtungsquelle 1300 ist somit im vorliegenden Beispiel mit einem Target bestückt, das mindetens die Elemente SiB enthält, bevorzugt eine Mischung aus BN und SiC.

Die SiBNC-Beschichtungsquelle 1300 wird weiter betrieben um, eine SiBNC-Schicht als erste Hartschicht 5 auf der Gradienten-Mischschicht 8 abzusscheiden. In einem darauf folgenden Verfahrensschritt erfolgt die Zufuhr eines Prozessgases, z.B. von Sauerstoff durch die Zuleitung 15 in die Prozesskamer 12, bevorzugt die Zuführung von Sauerstoff zum Aufbringen beispielsweise einer SiBNCO-Schicht als Sauerstoff-Hartschicht 9, die dann die Deckschicht 10 bildet, wobei das erfindungsgemässe Beschichtungsverfahren z.B. so durchgeführt wird, dass der Sauerstoffanteil in der Sauerstoffhartschicht in Richtung vom Substrat 3 weg, also nach aussen zur Oberfläche hin zunimmt.

Bevorzugt können bei einem erfindungsgemässen Verfahren die zu beschichtenden Substrate auf eine Tempertaur von ca. 300 - 800 °C aufgeheitzt werden. Sodann wird nach Erreichen eines üblichen Startdruckes (ca. 0.01Pa) eine lonenreinigung z.B. mittels des AEGD-Processes durchgeführt. Der AEGD-Prozess ist dem Fachmann wohlbekannt und braucht daher hier nicht im Detail diskutiert zu werden. Für die Aufbringung der Schichten, insbesondere der Verbundschicht, wird das DC-Magnetron oder der Arc-Vakuumbogen-Verdampfer mit dem geeignetem Kathodenmaterial benutzt.

Es versteht sich dabei, dass in der Prozesskammer 12 auch nur 1 oder aber auch drei oder mehr RF-Beschichtungsquellen 13 oder auch mehr als eine DC-Beschichtungsquelle 13 vorgesehen sein kann, je nach Anwendung und je nach dem welche Schichtzusammensetzungen im Einzelnen gewünscht sind.

So kann das oben exemplarisch beschriebene erfindungsgemässe Verfahren auch zum Beispiel mit drei RF-Beschichtungsquellen 13 durchgeführt werden, wenn besondere Anforderungen auf die aufzubringenden Schichten bzw. deren chemische Zusammensetzung gestellt sind.

### Beispiel 1:

Beladung des Substrathalters mit Mikrowerkzeugen aus Hartmetall.
1) Erwärmung der Werkzeuge auf 500 °C.
2) Ionenreinigung ca. 30 min bei 200V gepulster Vorspannung, positive Spannung 30V, (20kHz),Puls/Pause 4, im AEGD-Prozess.
3) Abscheidung einer Al70Cr30-Schicht durch DC-Sputtern, Target-Leistungsdichte 5 W/cm², Vorspannung 50 V.
4) Reaktive Schichtabscheidung von AlCrN durch Zugabe von N (Stickstoff).
5) Metallische Zwischenschicht wie unter Punkt 3 angegeben.
6) Einschalten des RF-targets mt dem Mischungsverhältnis der atomaren Zusammenstzung Si:B 1 zu 6.
7) Zugabe von N O (Stickstoff, Sauerstoff) zur Abscheidung der Abschlussschicht.

### Beispiel 2:

1) Erwärmung der Werkzeuge auf 500 °C.
2) Ionenreinigung für ca. 30 min bei 200V gepulster Vorspannung, positive Spannung 30V, (20kHz),Puls/Pause 4, im AEGD-Prozess.
3) Abscheidung einer TiAlSiN-Schicht mittels der Vakuumbogenverdampfungsquelle.
4) Einschalten des RF-Targets mit einem Target bestehend aus einer molaren Mischung BN plus SiC im Verhältnis 1 zu 1.
5) Zugabe von Stickstoff und Acetylen.
6) Zusätzliche Zugabe von Sauerstoff.

### Beispiel 3:

1) Erwärmung der Werkzeuge oder Verschleissteile auf 500 °C.
2) Ionenreinigung für ca. 30 min bei 200V gepulster Vorspannung, positive Spannung 30V, (20kHz),Puls/Pause 4, im AEGD-Prozess.
3) RF-Sputtern von SiC.
4) Einlassen von N (Stickstoff).
5) Zuschalten des RF-Targets wie in Beispiel 2, Punkt 4).
6) Abschalten des SiC Targets.

Übliche Drücke, bei denen das Sputtern stattfindet, können dabei typischerweise im Bereich von 0.1 bis 5 Pa liegen.

Bei der Lichtbogenbeschichtung (Arc-Beschichtung) wird typisch mit einem Entladungsstrom von 30 - 200 A gearbeitet. Gängige Arc-Kathoden Durchmesser sind zum Beispiel ca.100 mm. Die Drücke, unter denen die Lichtbogenbeschichtung stattfindet liegen zum Beispiel im Bereich von 1 Pa bis 10 Pa.

## Patentansprüche

1. Werkzeug oder Verschleissteil beschichtet mit einem Schichtsystem mit Schichten in einem weitgehend amorphen Zustand zur Bildung einer Oberflächenschicht auf einer Oberfläche (2) des Substrats (3), wobei das Schichtsystem mittels PVD hergestellt ist, wobei auf der Oberfläche (2) des Substrats (3) mindestens eine Verbundschicht (4) vorgesehen ist, und weiter mindestens eine erste Hartschicht (5) der Zusammensetzung SiₐB_{b}Me_{c}NᵤCᵥ mit a,b > 0 und 33 at% > c ≥0 und u,v > 0 vorgesehen ist und Me ein Metall ist, **dadurch gekennzeichnet, dass** auf der ersten Hartschicht (5) eine Sauerstoff-Hartschicht (9) als abschliessende Deckschicht (10) aus SiₐB_{b}CᵥNᵤO_{w}, mit a,b > 0 und u,v, w > 0 vorgesehen ist.

2. Werkzeug oder Verschleissteil nach Anspruch 1, wobei Me mindestens ein Metall aus der Gruppe Al, Cr, Mo, W, V,Nb, Ta, Ti, Zr, Hf, Mn, Fe; Co; Ni, Li, Be, Mg, Sc, Y, La, Ce, Nd, Sm ist.

3. Werkzeug oder Verschleissteil nach einem der Ansprüche 1 oder 2, wobei die Verbundschicht (4) aus MeₓE_{y}N_{z}, mit x > 0; y ≥ 0 und z > 0 vorgesehen ist, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.

4. PVD-Beschichtungsverfahren zum Aufbringen eines Schichtsystems (1) nach einem der Ansprüche 1 bis 3 auf eine Oberfläche (2) eines Werkzeugs (3) oder eines Verschleissteils (3), in einer Prozesskammer (12) einer Beschichtungsvorrichtung (11) mit einer RF-Beschichtungsquelle (13) mit einem RF-Magnetron und / oder einer DC-Beschichtungsquelle (1320), insbesondere mit einem DC-Magnetron, wobei die RF-Beschichtungsquelle (13) und / oder die DC-Beschichtungsquelle (1320) durch eine Blende (131,) verschlossen werden kann, und Mittel (15) vorgesehen sind, so dass der Prozesskammer (12) ein Prozessgas zuführbar ist, und das Verfahren die folgenden Verfahrensschritte umfasst:
a.) Einbringen des Substrats (3) in die Prozesskammer (12);
b.) Erhitzen des Substrats (3) auf die lonenreinigungstemperatur;
c.) lonenereinigung des Substrats (3) bei der lonenreinigungstemperatur;
d.) Abscheiden einer Verbundschicht (4) auf der Oberfläche (2) des Werkzeugs oder Verschleissteils (3),
e.) Abscheidung einer ersten Hartschicht (5) der Zusammensetzung SiₐB_{b}Me_{c}NᵤCᵥ mit a,b > 0 und 33 at% > c ≥0 und u,v > 0, wobei Me ein Metall ist, unter Verwendung der RF-Beschichtungsquelle (13) und / oder der DC-Beschichtungsquelle (1320)
f.) Zugabe eines Reaktivgases, insbesondere Sauerstoff, Stickstoff oder ein Kohlenstoff enthaltendes Gas, in die Prozesskammer (12) und Bildung einer Sauerstoff-Hartschicht (9) als abschliessende Deckschicht (10) aus SiₐB_{b}CᵥNᵤO_{w}, mit a,b > 0 und u,v, w > 0.

5. PVD-Beschichtungsverfahren nach Anspruch 4 umfassend die folgenden weiteren Verfahrensschritte:
a.) Ionenereinigung des Werkzeugs (3) oder Verschleissteils (3) bei der Ionenreinigungstemperatur und Anlegen einer Bias Gleichspannung (16) und / oder einer RF-Spannung (16) an das Substrat (3);
b.) Öffnen der Blende (1303) der DC-Beschichtungsquelle (1320) und / oder der Blende (1301) einer ersten RF-Beschichtungsquelle (1300);
c.) Abscheiden einer Verbundschicht (4) auf der Oberfläche (2) des Werkzeugs (3) oder Verschleissteils (3) aus MeₓE_{y}N_{z}, mit x,y ≥ 0 und z > 0, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.
d.) Deaktivieren der DC-Beschichtungsquelle (1320) und / oder der ersten RF-Beschichtungsquelle (1300), Öffnen einer Blende (1302) einer zweiten RF-Beschichtungsquelle (1310) und in Betriebnahme der zweiten RF-Beschichtungsquelle (1310);
e.) Abscheiden einer Zwischenschicht (7) umfassend die Elemente Si und / oder C mittels der zweiten RF-Beschichtungsquelle (1310);
f.) Öffnen einer Blende einer dritten RF-Beschichtungsquelle, in Betriebnahme der dritten RF-Beschichtungsquelle und im Parallebetrieb mit der zweiten RF-Beschichtungsquelle (1310) Abscheidung von SiₐB_{b}Me_{c}CᵥNᵤ, im speziellen von SiₐB_{b}CᵥNᵤ der ersten Hartschicht (5) mittels der zweiten RF-Beschichtungsquelle zur Bildung einer Gradienten-Mischschicht (8);
g.) Deaktivieren der zweiten RF-Beschichtungsquelle (1310) und Abscheiden einer ersten Hartschicht (5) aus SiₐB_{b}Me_{c}NᵤCᵥO_{w}, insbesondere SiₐB_{b}Me_{c}CᵥNᵤ, im speziellen SiₐB_{b}CᵥNᵤ beim Weiterbetrieb der dritten RF-Beschichtungsquelle bis zu einer vorgegebenen Beschichtungsdicke der ersten Hartschicht (5);

6. Beschichtungsverfahren nach einem der Ansprüche 4 oder 5, wobei die DC-Beschichtungsquelle (1320) und / oder die RF-Beschichtungsquelle (13) eine Sputterquelle und / oder eine Lichtbogen-Verdampfungsquelle ist.

7. Beschichtungsverfahren nach einem der Ansprüche 4 bis 6, wobei der Beschichtungsvorgang mittels eines PVD-Verfahrens, bevorzugt mittels RF-Sputtern und / oder DC-Sputtern und oder mittels lonenimplantation und / oder mittels Laserablation und /oder mittels einem Lichtbogenverdampfungsverfahren, insbesondere mittels einem kathodischen und / oder anodischen Lichbogenverdampfungsverfahren durchgeführt wird.

8. Werkzeug nach Anspruch 1-3, wobei das Werkzeug ein spannendes Werkzeug (3), insbesondere ein Bohrer (3), ein Fräser (3), eine Wendeschneidplatte (3) für einen Dreh- oder Fräsprozess oder ein Hobelwerkzeug (3), ein Umformwerkzeug (3) oder ein Mikrowerkzeug (3), insbesondere ein Mikrobohrer (3), eine Mikrowendeschneidplatte (3), ein Mikrofräser (3) oder ein anderes Werkzeug (3) oder Mikrowerkzeug (3) oder ein Kunststoffwerkzeug (3) ist.

9. Verschleissteil (3) nach Anspruch 1-3 für eine Luft- oder Land gestützte Turbine, einen Motor, im Speziellen für einen Verbrennungsmotor, im speziellen eine Dichtung (3), ein Zahnrad (3), ein Kolben (3) oder ein anderes Verschleissteil (3) ist.

## Claims

1. Tool or wearing part (3) coated with a layer arrangement with layers are largely in an amorphous state for the formation of a coating on a surface (2) of the substrate (3), wherein the layer arrangement is deposited by means of PVD, and on the surface (2) of the substrate (3) at least one connecting layer (4) is provided, wherein at least a first hard layer (5) is provided having the composition SiₐB_{b}Me_{c}NᵤCᵥ with a,b > 0 and 33 at% > c ≥0, and u,v > 0, and Me being a metal,
**characterized in, that**
on the first hard layer (5) a oxygen hard layer (9) as a protective hard layer (10) is provided, having the composition SiₐB_{b}CᵥNᵤO_{w}, with a,b > 0 und u,v, w > 0.

2. Tool or wearing part (3) in accordance with claim 1, wherein Me is at least one metal of the group consisting of Al, Cr, Mo, W, V, Nb, Ta, Ti, Zr, Hf, Mn, Fe, Co, Ni, Li, Be, Mg, Sc, Y, La, Ce, Nd, Sm.

3. Tool or wearing part (3) in accordance with claim 1 or 2, wherein the connecting layer (4) having the composition MeₓE_{y}N_{z}, with x > 0, y ≥ 0 and z > 0 wherein Me is at least one metal of the group consisting of Al, Cr, Mo, W, V, Nb, Ta, Ti, Zr, HF, Mn, Fe, Co, Ni, Li, Be, Mg, Sc, Y, La, Ce, Nd, Sm and E being an element of the group consisting of Si, B, C, O.

4. PVD-Coating method for depositing a layer arrangement (1) in acordance with anyone of the preceding claims 1 to 3 onto the surface (2) of a tool (3) or wearing part (3), wherein in a process chamber (12) of a coating apparatus (11) a RF-coating source (13), having a RF-magnetron and / or a DC-coating source (1320), in particular a DC-magnetron, is provided, wherein the RF-coating source (13) and / or the DC-coating source (1320) can be closed by a shutter (131), and wherein means (15) are provided, so that a process gas can be supplied into the process chamber (12), and said coating method comprising the following steps:
a.) placing the substrate (3) into the process chamber (12);
b.) heating the substrate (3) to a ion-cleaning temperature;
c.) ion-cleaning of the substrate (3) at the ion-cleaning temperature;
d.) deposition of a connecting layer (4) onto the surface (2) of the tool or wearing part (3),
e.) deposition of a first hard layer (5) having the composition SiₐB_{b}Me_{c}NᵤCᵥ with a,b > 0 and 33 at% > c ≥0 and u,v > 0, and Me being a metal, using the RF-coating source (13) and / or the DC-coating source (1320)
f.) feeding a reactive gas, especially oxygen, nitrogen, or a carbon containing gas, into the process chamber (12) and depositing an oxygen hard layer (9) as a protective hard layer (10), having the composition SiₐB_{b}CᵥNᵤO_{w}, with a,b > 0 und u,v, w > 0.

5. PVD-Coating method in accordance with claim 4 comprising the following steps:
a.) ion-cleaning of the tool or wearing part (3) at the ion-cleaning temperature and feeding a bias constant-voltage (16) and / or a RF-Voltage (16) to the substrate (3) to achieve an ion-cleaning;
b.) opening the shutter (1303) of the DC-coating source (1320) and / or the shutter (1301) of a first RF-coating source (1300);
c.) deposition of a connecting layer (4) onto the surface (2) of the tool or wearing part (3) having the composition MeₓE_{y}N_{z}, with x,y ≥ 0 and z > 0, wherein Me is at least a metal of the group consisting of Al, Cr, Mo, W, V,Nb, Ta, Ti, Zr, HF, Mn, Fe, Co, Ni, Li, Be, Mg, Sc, Y, La, Ce, Nd, Sm and E being an element of the group consisting of Si, B, C, O;
d.) deactivating the DC-coating source (1320) and / or eht first RF-coating source (1300), opening a shutter (1302) of a second RF-coating source (1310) and putting said second RF-coating source (1310) into operation;
e.) deposition of an intermediate layer (7) comprising the elements Si and / or C by using the second RF-coating source (1310);
f.) opening a shutter of a third RF-coating source, putting said third RF-coating source into operation and depositing in parallel with the second RF-coating source (1310) SiₐB_{b}Me_{c}CᵥNᵤ, in more particular SiₐB_{b}CᵥNᵤ according to the first hard layer (5) by means of the second RF-coating source (1310) in order to deposit a gradient-mixed layer (8);
g.) deactivating the second RF-coating source (1310) and depositing a first hard layer (5) having the composition SiₐB_{b}Me_{c}NᵤCᵥO_{w}, in particular SiₐB_{b}Me_{c}CᵥNᵤ, in more particular SiₐB_{b}CᵥNᵤ and keeping the third-coating source in operation until a presetted thickness of the first hard layer (5) is deposited;

6. Coating method in accordance with anyone of claims 4 or 5, wherein the DC-coating source (1320) and / or the RF-coating source (13) is a sputter-source and / or an arc evaporating source.

7. Coating method in accordance with anyone of claims 4 to 6, wherein the coating process is carried out by means of a PVD-method, in particular a RF-sputter method and / or a DC-sputter method and / or a CVD-method, especially a PE-CVD method and / or a Laser-CVD method, and / or an ion-implantation method and / or a laser-ablation method and / or an arc-evaporation method, especially a cathodic and / or anodic arc-evaporation method.

8. Tool in accordance with anyone of the preceding claims 1 to 3, wherein the tool (3) is a cutting tool (3), especially a drill (3), a milling cutter (3), a tool (3) for a turning lathe or a plane (3), a conversion tool (3) or a micro tool (3), in particular a micro-tool (3), a mirco-indexable insert (3), a micro-milling cutter (3) or another tool (3) or a micro tool (3) or a plastic tool.

9. Wearing part (3) in accordance with anyone of the preceding claims 1 to 3 for an air- or land-based turbine, for an engine, especially for a combustion engine, in particular a gasket (3), a gearwheel (3), a piston (3) or another wearing part (3).

## Revendications

1. Un outil ou une pièce d'usure revêtue d'un système de couches avec des couches dans un état largement amorphe pour la formation d'une couche superficielle sur une surface (2) du substrat (3), dans lequel le système de couches est produit au moyen de PVD, dans lequel au moins une couche composite (4) est prévue sur la surface (2) du substrat (3) et en outre au moins une première couche dure (5) de la composition SiₐB_{b}Me_{c}NᵤCᵥ avec a,b > 0 et 33 at% > c ≥0 et u,v > 0 est prévue et Me est un métal, **caractérisé en ce qu'**une couche dure d'oxygène (9) est prévue sur la première couche dure (5) en tant que couche supérieure finale (10) de la composition SiₐB_{b}CᵥNᵤO_{w} avec a,b > 0 et u,v,w > 0.

2. Un outil ou une pièce d'usure selon la revendication 1, dans lequel Me est au moins un métal du groupe Al, Cr, Mo, W, V, Nb, Ta, Ti, Zr, Hf, Mn, Fe; Co; Ni, Li, Be, Mg, Sc, Y, La, Ce, Nd, Sm.

3. Un outil ou une pièce d'usure selon l'une des revendications 1 ou 2, dans lequel la couche composite (4) est prévue de la composition MeₓE_{y}N_{z}, avec x > 0; y ≥ 0 et z > 0, dans lequel Me est au moins un métal du groupe Al, Cr, Mo, W, V, Nb, Ta, Ti, Zr, HF, Mn, Fe; Co; Ni, Li, Be, Mg, Sc, Y, La, Ce, Nd, Sm et E est un élément du groupe Si, B, C, O.

4. Procédé de revêtement PVD pour l'application d'un système de couches (1) selon l'une des revendications 1 à 3 sur une surface (2) d'un outil (3) ou d'une pièce d'usure (3), dans une chambre de traitement (12) d'un dispositif de revêtement (11) avec une une source de revêtement RF (13) avec un magnétron RF et / ou une source de revêtement à courant continu (1320), en particulier avec un magnétron à courant continu, dans lequel la source de revêtement RF (13) et / ou la source de revêtement à courant continu (1320) peut être fermée par un diaphragme (131) et des moyens (15) sont prévus pour qu'un gaz de processus puisse être introduit dans la chambre de traitement (12), et le procédé comprend les étapes du procédé suivantes:
a) L'introduction du substrat (3) dans la chambre de traitement (12) ;
b) Le chauffage du substrat (3) à la température de nettoyage ionique;
c) Le nettoyage ionique du substrat (3) à la température de nettoyage ionique;
d) Le dépôt d'une couche composite (4) sur la surface (2) de l'outil ou de la pièce d'usure (3),
e) Le dépôt d'une première couche dure (5) de la composition SiₐB_{b}Me_{c}NᵤCᵥ avec a,b > 0 et 33 at% > c ≥0 et u,v > 0, dans lequel Me est un métal, utilisant la source de revêtement RF (13) et / ou la source de revêtement à courant continu (1320)
f) L'ajout d'un gaz réactif, en particulier de l'oxygène, de l'azote ou d'un gaz carboné dans la chambre de traitement (12) et la formation d'une couche dure d'oxygène (9) en tant que couche supérieure finale (10) de la composition SiₐB_{b}CᵥNᵤO_{w} avec a,b > 0 et u,v,w > 0.

5. Un procédé de revêtement PVD selon la revendication 4 comprenant les étapes de procédé supplémentaires suivantes :
a) Le nettoyage ionique de l'outil (3) ou de la pièce d'usure (3) à la température de nettoyage ionique et l'application d'une tension de polarisation en courant continu (16) et / ou une tension RF (16) au substrat (3);
b) L'ouverture du diaphragme (1303) de la source de revêtement à courant continu (1320) et / ou du diaphragme (1301) d'une première source de revêtement RF (1300);
c) Le dépôt d'une couche composite (4) sur la surface (2) de l'outil (3) ou de la pièce d'usure (3) de la composition MeₓEyN_{z}, with x,y ≥ 0 and z > 0, dans lequel Me est au moins un métal du groupe Al, Cr, Mo, W, V, Nb, Ta, Ti, Zr, HF, Mn, Fe; Co; Ni, Li, Be, Mg, Sc, Y, La, Ce, Nd, Sm et E est un élément du groupe Si, B, C, O.
d) La désactivation de la source de revêtement à courant continu (1320) et / ou de la première source de revêtement RF (1300), l'ouverture d'un diaphragme (1302) d'une deuxième source de revêtement RF (1310) et la mise en service de la deuxième source de revêtement RF (1310);
e) Le dépôt d'une couche intermédiaire (7) comprenant les éléments Si et / ou C au moyen de la deuxième source de revêtement RF (1310);
f) L'ouverture d'un diaphragme d'une troisième source de revêtement RF, la mise en service de la troisième source de revêtement RF et en fonctionnement parallèle avec la deuxième source de revêtement RF (1310) le dépôt de SiₐB_{b}Me_{c}CᵥNᵤ, en particulier de SiₐB_{b}CᵥNᵤ de la première couche dure (5) au moyen de la deuxième source de revêtement RF pour la formation d'une couche mélangée de gradient (8);
g) La désactivation de la deuxième source de revêtement RF (1310) et le dépôt d'une première couche dure (5) de la composition SiₐB_{b}Me_{c}NᵤCᵥO_{w}, en particulier SiₐB_{b}Me_{c}CᵥNᵤ, spécialement SiₐB_{b}CᵥNᵤ pendant de la poursuite du fonctionnement de la troisième source de revêtement RF jusqu'à une épaisseur de revêtement prédéterminée de la première couche dure (5);

6. Un procédé de revêtement selon l'une des revendications 4 ou 5, dans lequel la source de revêtement à courant continu (1320) et / ou la source de revêtement RF (13) est une source de pulvérisation et / ou une source d'évaporation par arc.

7. Un procédé de revêtement selon l'une des revendications 4 à 6, dans lequel le procédé de revêtement est effectué au moyen d'un procédé PVD, de préférence au moyen de pulvérisation RF et / ou de pulvérisation à courant continu et / ou au moyen d'implantation d'ions et / ou au moyen d'ablation laser et / ou au moyen d'un procédé d'évaporation par arc, en particulier au moyen d'un procédé d'évaporation par arc cathodique et / ou anodique.

8. Un outil selon la revendication 1 à 3, dans lequel l'outil est un outil de coupe (3), en particulier un foret (3), une fraise (3), une plaquette amovible (3) pour un processus de tournage ou de fraisage ou un outil de rabotage (3), un outil de formage (3) ou un micro-outil (3), en particulier un micro-foret (3), une micro-plaquette amovible (3), une micro-fraise (3) ou un autre outil (3) ou un micro-outil (3) ou un outil en plastique.

9. Une pièce d'usure (3) selon la revendication 1 à 3 pour une turbine aérienne ou terrestre, un moteur, spécialement pour un moteur à combustion, spécialement un joint (3), une roue dentée (3) un piston (3) ou une autre pièce d'usure (3).
